Europäisches Patentamt

European Patent Office

Office européen des brevets

(11) Publication number: **0 157 220**
**A1**

## (12) EUROPEAN PATENT APPLICATION

(21) Application number: **85102651.8**

(22) Date of filing: **08.03.85**

(51) Int. Cl.⁴: **H 03 K 17/08, H 02 H 7/122, H 02 M 7/538**

(30) Priority: **08.03.84 NZ 207433**

(43) Date of publication of application: **09.10.85**
**Bulletin 85/41**

(84) Designated Contracting States: **AT BE CH DE FR GB IT LI LU NL SE**

(71) Applicant: **FISHER & PAYKEL LIMITED, Mount Wellington Highway, Mount Wellington Auckland (NZ)**

(72) Inventor: **Cheyne, Neil Gordon c/o Fisher & Paykel Ltd., Mt. Wellington Highway, Mt. Wellington Auckland (NZ)**

(74) Representative: **Brown, John David et al, FORRESTER & BOEHMERT Widenmayerstrasse 4/I, D-8000 München 22 (DE)**

(54) Improvements in or relating to electronic control circuits.

㊗ A switching bridge having at least one switching stage (10) for rapidly coupling and uncoupling at least one inductive load (18) across a source of power (V supply) for pulsing current therethrough in either of two directions, the at least one stage (10) comprising:

first and second switch circuits (10a, 10b), each said switch circuit (10a, 10b) comprising, corresponding thereto,

a power switch (Q1, Q2), the power switch (Q1, Q2) of each said switch circuit (10a, 10b) being coupled together to the other one in a series circuit path across said source of power (V supply), each power switch (Q1, Q2), when on, being adapted for serially coupling a different side of the source of power (V supply) to an output circuit (17) and, when off, being adapted for disabling the coupling, the load (18) being coupled between the output circuit (17) and the other side of the source of power (V supply) from the one coupled by one of the power switches (Q1, Q2) to the output circuit (17),

a capacitor snubber (C1, R1, D1; C2, R2, D2) coupled across the power switch (Q1, Q2), in the corresponding switch circuit (10a, 10b), for limiting rate of change of voltage across such power switch (Q1, Q2), in at least one direction of voltage change;

unidirectional circuit means (D3, D4) coupled to such output circuit (17) for directing decay current, flowing in the at least one load (18), in a loop back through the at least one load

(18) upon turning the power switch (Q1, Q2), corresponding to the other said switch circuit (10b, 10a), from on to off; and

further unidirectional circuit means (D5, D6) located in the series circuit path for inhibiting the discharge of charge previously stored in the capacitor snubber (C1, R1, D1; C2, R2, D2) of the corresponding switch circuit (10a, 10b) until the power switch (Q1, Q2) of the corresponding switch circuit (10a, 10b) is turned on, each of the further unidirectional circuit means (D5, D6) also being adapted to be maintained in a back biased condition, due to the charge stored in the capacitor snubber (C1, R1, D1; C2, R2, D2), of the corresponding switch circuit (10a, 10b), to thereby substantially isolate the corresponding switch circuit (10a, 10b) from signal changes in the other of the switch circuits (10b, 10a).

IMPROVEMENTS IN OR RELATING TO ELECTRONIC
CONTROL CIRCUITS

This invention relates to electronic control circuits and has been devised particularly though not solely to control an electronically commut. ed motor driving a clothes washing machine.

BACKGROUND OF INVENTION

This invention relates to electronic power control circuits and/or methods or operating the same and more particularly to totem pole switching circuits for rapidly coupling and uncoupling an inductive load across a source of power for pulsing current therethrough in either of two directions.

Forward bias safe operating area (FBSOA) is a published operting parameter for switching transistors and is a measure of the ability of the device to handle stress when its base is forward biased. The FBSOA curve contains maximum limits for both steady state and turn on load lines in terms of collector current ($I_c$), collector - emitter voltage ($V_{CE}$) and time. Temperature derating applies.

Since it is possible to have a positive base - emitter voltage ($V_{BE}$) and a negative base current during storage time, forward bias is defined in terms of base current. The FBSOA curve applies when turn on base current is flowing or when the base is open circuit. When turn off base current is flowing, even if the source is merely a base-emitter resistor, reverse bias safe operate area (RBSOA) applies.

The RBSOA curve is a measure of the simultaneous peak

0157220

2

collector current and peak clamp voltage that the device can withstand. Typical FBSOA and RBSOA curves are available for various types of power switching devices. RBSOA, unlike FBSOA, is independent of temperature and time. However, RBSOA is strongly influenced by the turn off base bias conditions.

In a circuit consisting of an inductive load in parallel with a free-wheel diode and in series with a power switching VCE has to rise at least a diode drop above the supply voltage $V^S$ and in practice can overshoot $V^S$ by several volts before the free wheel diode turns on. Collector current can start to reduce only when the diode starts to conduct since load current is essentially constant.

Thus the turn off load line is such that, since maximum $V_{CE}$ and maximum $I_C$ occur simultaneously.

If the turn off load line exceeds the RBSOA, then either another device has to be chosen for the application, or a snubber has to be used. The latter approach is frequently more cost effective.,

A capacitor snubber typically a resistor in series with a capacitor connected in parallel with the switching device obeys the relationship $I = C\frac{dv}{dt}$ where I is the inductive load current flowing prior to turn off and $\frac{dv}{dt}$ is the rate of change of voltage across the switching device. By choice of a suitable capacitance $\frac{dv}{dt}$ can be reduced so that peak voltage across the switching device and peak

0157220

3

current through the switching device do not occur simultaneously.

Power switching devices other than transistors have switching load line limitations which are analogous to the FBSOA and RBSOA of transistors. The terms FBSOA and RBSOA are not used with other devices and the parameters and their interdependence are different. Gate turn off (GTO) devices, for example, have their safe operation conditions and are defined differently. Thus there is a maximum allowable rate of change of reapplied voltage $\frac{dVD}{dt}$ at turn off and this is a function of anode current, temperature and gate drive conditions. Snubbers can be used to control this $\frac{dVD}{dt}$ in a similar way as for transistors. The turn off loss of the GTO can be reduced by reducing $\frac{dVD}{dt}$, but this means that the snubber capacitance must be increased. A larger snubber capacitance has the beneficial effect of permitting higher values of controllable anode current, but has the detrimental effect of adding to the turn on losses due to snubber capacitor dischrge (snubber losses).

Most applications have clearly defined values of peak anode current which must be controlled. If the application does not impose any requirement on $\frac{dVD}{dt}$, then snubber losses can be minimized by choosing C such that the turn off dV/dT is the highest the device can safely withstand for that value of peak anode current. The snubber capacitance is simply determined by the relationship $I = C\frac{dv}{dt}$ If this capacitance is sufficiently low, it may be

P.05

4

connected directly across the GTO. In a bridge circuit, a value of 1/2 C should be used across each GTO with good D.C. power supply decoupling so that the upper and lower snubber capacitors effectively act in parallel. The maximum value of capacitance which may be used in this way is limited, in the case of GTO's, by peak anode current caused by its discharge at turn on. A similar argument applies if transistor is used, the maximum value of capacitance being limited by the shape of FBSOA.

If in either case the maximum allowed capacitance is still not large enough to control turn off, then polarized resistance-capacitor-diode (RCD) snubbers, in which the resistor controls turn on current, require consideration and the present invention has therefore been devised in the preferred form to enable RCD snubbers to be used in relation to pairs of power switching devices arranged in totem pole output configurations and connected to an inductive load.

Also, if the turn-off load line of collector current as a function of collector-emitter voltage exceeds the RBSOA, then either another device must be chosen for the application, or a snubber must be used. The latter approach is frequently more cost effective.

A capacitor snubber connected in parallel with the switching device obeys the relationship $I = C\frac{dV}{dt}$ where I is the inductive load current flowing prior to turn-off and $dt$ is the rate of change of voltage across the switching

0157220

$S$

device. By choice of a suitable capacitance, $dt$ can be reduced so that peak voltage and current do not occur simultaneously.

An RDC snubber at turn-off functions as a simple capacitor snubber since it charges via the diode. At turn-on, however, the RCD snubber offers the advantage of reduced peak discharge current through the switching device because the capacitor discharge circuit involves the resistor. The stored energy in the snubber capacitance is the same in both cases, provided that the capacitance value is the same, but the dicharge time constant is longer in the case of the RCD snubber.

While RCD snubbers offer advantage over capacitor only snubbers, in single power switch configuration these advantages are nullified to some extent when the power switching devices are connected in a totem pole bridge ourcuit where the switches are connected in series between the opposite sides of the power supply and the output circuit is at the junction between the two. When, for example, the upper switch switches off, the snubber capacitor for the upper switch is charged by inductive load current flowing via snubber diode as intended. However, snubber capacitor for the lower switch is discharged by inductive load current flowing via its resistor, eventually becoming completely discharged shortly after the voltage A at the output has been clamped at the positive supply coltage $V_S$ by the upper free wheel diode.

6

The discharging of the upper snubber capacitor is not a problem at this stage of the circuit operation, but consider what happens when the lower power switchsubsequently turns on. As the voltage output falls the lower snubber capacitor discharges through the lower power switch in a controlled way via the resistor of the lower snubber as intended and if snubber component values have been correctly chosen, the FBSOA or peak current ratings of the switching device are not exceeded. However, the upper snubber capacitor charges through the lower power switch in an uncontrolled way via the upper snubber diode and so the lower power switch receives the high current pulse at turn-on that one tries to avoid by using RCD snubbers in the first place.

The circuit is symmetrical in that the same problem occurs at turn-on of the upper power switch. The lower snubber capacitor, having been discharged when the upper power switch was off, is charged through the upper power switch via the lower snubber diode and again the undesirable current pulse at turn-on is the result.

One possible solution known in the prior art adds an additional inductance inserted in the main supply rail in series with any main rail capacitor and the upper side of the power switch in the totem pole stage. The inductance must be bypassed by its own free wheel diode.

The inductance has the effect of reducing the rate of rise of snubber capacitor charging current at the turn-on

7

of the power switch. However, current flows through the upper snubber capacitor and diode and the lower power switch from the supply. The voltage across the inductor is given by V - Ldi/dt and so the supply voltage and the voltage waveform at the output are distorted by the value of the voltage across the inductor. This is a problem if accurate detection of the output voltage is required, for example, for control purposes.

Certain types of power switches that are manufactured for commercial use include an internal parasitic diode, an example of which being a power MOSFET. This parasitic diode is an inherent part of the device construction and operates to prevent the device from supporting reverse voltage. When two of such power swtiches, without RCD snubber circuits, are serially connected together across opposite sides of a power source and the common junction therebetween is used to drive an inductive load, this parasitic diode can function as a free wheel diode. Compared with many discrete diodes, parasitic diodes are reasonably fast, but their forward and reverse recovery times are slow compared to the speed with which the power switch can switch on and switch off, hence making it prone to failure. Further, when considering a power MOSFET, the parasitic diode is the base-collector junction of a parasitic bipolar transistor that is also inherent in MOSFET construction. False turn-on of this bipolar can also cause MOSFET failure.

8

Manufacturers generally acknowledge that parasitic diodes are not suitable for some high speed free wheeling circuits. In these cases a discrete diode is placed in series with each power switch and the output, between the two power switches, prevents activating the parasitic diode. A second discrete diode in parallel with each of the power switches and series diode pairs, provides the free wheeling action for the inductive load at turn-off.

## SUMMARY OF THE INVENTION

The present invention offers solutions to the problems outlined above. An embodiment of this invention is in a totem pole switch circuit with RCD snubbers across the upper and lower power switches but includes series connected diodes between each power switch and the output. The use of these diodes is not to block the action of any parasitic diodes, but to control the conditions of charge and discharge of the snubber capacitors and to isolate each power switch circuit from the other one. If parasitic diodes are present and snubbers are required, the series diodes of the present invention can serve dual functions.

An embodiment of the present invention is a switching bridge which has a switching stage for rapidly coupling and uncoupling an inductive load across a source of power for pulsing current therethrough in either of two directions. The stage has first and second switch circuits. Each switch circuit has a power switch, a capacitor snubber; an unidirectional circuit, and a further unidirectional

9

circuit. More specifically the power switch of each switch circuit is coupled together to the other one in a series circuit path. Each power switch, when on, is adapted for serially coupling a different side of the source of power to an output circuit. When off, the power switch is adapted for disabling the coupling. The load is coupled between the output circuit and the other side of the source of power from the one coupled to the output circuit by the power switch. The capacitor snubber is coupled across the power switch, in the corresponding switch circuit, and limits the rate of change of voltage across the power switch in at least one direction of voltage change. The unidirectional circuit is coupled to the output circuit for directing decay current, flowing in the load, in a loop back through the load upon turning the power switch, corresponding to the other switch circuit, from on to off. The further unidirectional circuit is located in the series circuit path for inhibiting the discharge of charge previously stored in the capacitor snubber of the corresponding switch circuit, until the power switch of the corresponding switch circuit is turned on. Each of the further unidirectional circuits is also adapted to be maintained in a back biased condition due to the charge stored in the capacitor snubber, of the corresponding switch circuit, to thereby substantially isolate the corresponding switch circuit from signal changes in the other of the switch circuits.

/10

## BRIEF DESCRIPTION OF THE DRAWINGS

Figure 1 is a schematic and block diagram of a microprocessor controlled totem pole snubber bridge driving an inductive load and embodies the present invention;

Figure 2 is a schematic and block diagram of an alternate embodiment of the present invention similar to that depicted in Figure 1 showing delay circuits for delaying the turn on time of the power switches;

Figure 3 is a multistage totem pole snubber bridge driving a multiphase motor, as the inductive load, and embodies the present invention;

Figure 4 is a block diagram of a multistage totem pole snubber bridge and motor of Figure 3, embodied in a laundry machine, controlled by a microprocessor, and embodies the present invention;

Figure 5 is a waveshape diagram illustrating the sequence of turning on the power switches in Figure 3 and the sequence of applying pulse width modulated signals to the "on" switches in accordance with the present invention.

## DESCRIPTION OF THE PREFERRED EMBODIMENT

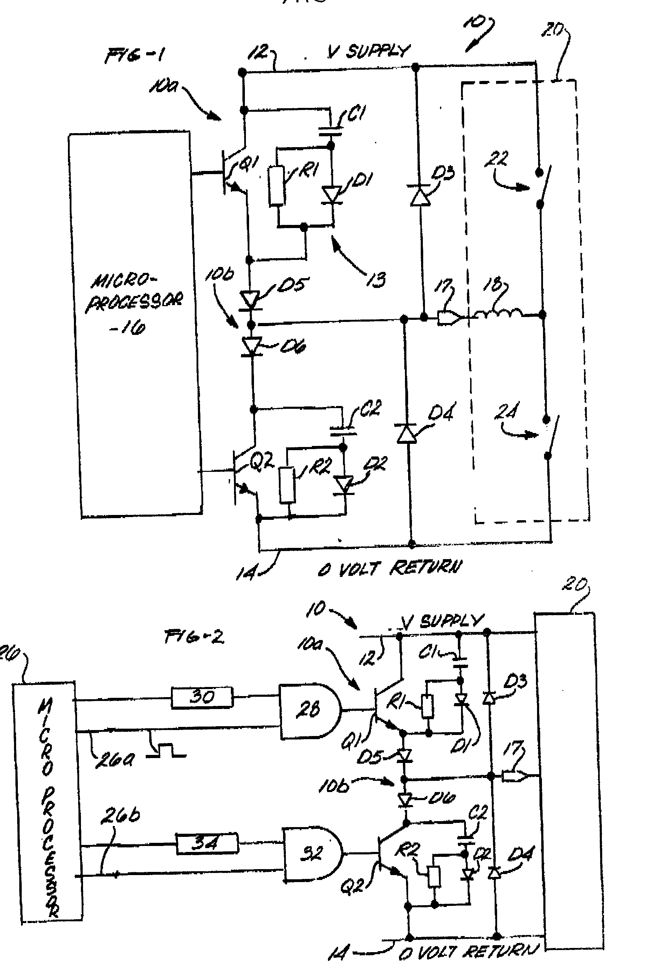

Figure 1 depicts a totem pole snubber bridge 10 connected between a positive rail 12 and a negative or zero volt return rail 14 of a source of power called V supply for the load. Considering the totem pole snubber bridge 10 in more detail, the bridge includes two switch circuits indicated generally at 10a and 10b. The switch circuits are connected together in series between the rails 12 and

∧∧

14 of the V supply and the junction therebetween is connected to an output 17 through which current is passed to a load generally indicated at 20.

Each of the switch circuits 10a and 10b is essentially the same. Accordingly only the components of switch circuit 10a will now be described. Switch circuit 10a includes a power switch of any suitable type such as a Bipolar transistor or preferably a GTO thyristor. By way of example and for clarity the power switch shown in the drawings is a transistor Q1 which has in parallel therewith, a capacitor snubber, preferably a resistor-capacitor-diode (RCD) snubber circuit 13. By way of example, the snubber circuit includes a capacitor C1 which is coupled in parallel with the collector emitter electrodes of transistor Q1. Also in series circuit with the capacitor C1 is a unidirectional circuit means in the form of diode D1 which provides a low impedance path through capacitor C1 from the collector to emitter diode, if transistor Q1 and a high impedance path in the reverse direction. A resistor R1 is coupled in parallel with the diode D1, and thus in series with the capacitor C1, across the collector emitter electrodes of transistor Q1.

Unidirectional circuit means in the form of a free wheel diode D3 is connected between the positive rail 12 of V supply and the output 17. To be explained in more detail, it is polarised so as to allow current flowing to the positive rail 12 from the output circuit 17 through the

*12*

inductive load to continue flowing in the same direction through the load after the power switch in switch stage B has been turned off.

A further unidirectional circuit means in the form of an isolation diode D5 is connected between the emitter electrode 21 of transistor Q1 and the output circuit 17. The transistor Q1 is an NPN type transistor with its emitter connected to the anode electrode of isolation diode D5. The cathode electrode of diode D5 is connected to the output circuit 17.

The switch circuit B is similar to switch circuit A. The same reference symbols are used to identify the components of switch B as are used in switch circuit A, with the number after the letter modified. The corresponding components are as follows:

| Switch Circuit A | Switch Circuit B |
|:---:|:---:|
| Q1 | Q2 |
| C1 | C2 |
| D1 | D2 |
| R1 | R2 |
| D3 | D4 |
| D5 | D6 |

The switch circuit 10b has transistor Q2, diode D2 and diode D6 polarized so that positive current flows from the output circuit 17 or from the switch circuit 10a down towards the O volt return rail 14, and diode D4 is polarized so that current flows from the rail 14 towards the output 17.

13

Thus it will now be seen that the switch circuits are connected in a totem pole configuration.

Significantly and to be explained in more detail, capacitor C1 is charged plus to minus from rail 12 to the junction of resistor R1 and diode D1 while transistor Q1 is off presenting a high impedance or substantially open condition between rail 12 and output 17. Further, after several on-off cycles of the transistor switch the voltage across the capacitor C1 is substantially equal to the voltage across the V supply, between rails 12 and 14 and, as a result, isolation diode D5 is maintained in a back biased condition. Hence, switching in switch circuit 106 does not affect the switch circuit 10a above diode D5 and, as a result, capacitor C1 remains fully charged. This is significant in that when transistor Q2 is subsequently switched on, it does not draw any charging current through capacitor C1. There will be a surge current at turn on due to the reverse recovery of diode D3, the discharge of capacitor C2 and the load current and these currents must be taken into account when rating transistor Q2. However there will not be the additional current from capacitor C1 in the transistor. Similarly, capacitor C2 is charged, preferably to the voltage between rails 12 and 14, with a positive voltage at the cathode of diode D6 with respect to the junction between resistors R2 and diode D2 and therefore when transistor Q2 is off, diode D6 is back biased, preventing any operation within switch circuit 10a

Λ4

from affecting the circuits of switch circuit 10b below diode D6. Most significantly, the charge on capacitor C2 remains, is not discharged and therefore when transistor Q1 turns on, no charging current flows from capacitor C2 through transistor Q1, thereby minimizing peak currents in the transistor.

Consider now the operation of the totem pole snubber bridge 10 in more detail. The load 20 is depicted schematically, by way of example, as an inductor 18 connected between the output circuit 17 and switches 22 and 24. Switch 22 couples the opposite side of inductor 18 from the output 17 to rail 12, whereas switch 24 couples it to rail 14.

If power is applied between rails 12 and 14 for a substantial time interval, without turn on of the transistors, capacitors C1 and C2 will charge up to approximately 1/2 the voltage of V supply via the path C1, D1, D5, D6, C2 and D2. This initial charging of the capacitors is not essential to the present invention.

Assume that microprocessor 16 switches transistor Q2 on, forming a low impedance path thereacross, and effectively shorting its collector emitter electrode together. Any charge on capacitor C2 will have a controlled discharge through the transistor via resistor R2 and capacitor C2. Also assume that switch 22 is closed, coupling inductor 18 to the rail 12. Positive current will then start to flow through the inductive load, transistor Q2 and diode D6 from rail 12 to rail 14. Assuming that capacitor C1 is fully charged, diode D5 is back biased and therefore does not contribute to the current through transistor Q2. However, assume that capacitor C1 were only half charged diode D5 is therefore not back biased and transistor Q2 would receive some current through capacitor C1, but the load current at this time is effectively zero. Due to this zero inductive load current the current flow through capacitor C1 is at such a level that it would not harm transistor Q2.

Microprocessor 16 maintains transistor Q2 on long enough for capacitor C2 to discharge to a level such that when transistor Q2 turns off the resulting load line is within transistor Q2's safe operating area. This is important since if residual charge remains on the capacitor, the turn off across transistor Q2 wull not be preferably controlled by the snubber until voltage across the transistor reaches the residual voltage on capacitor C2.

Assume now that microprocessor 16 switches the transistor Q2 off and switch 22 remains closed. The current flowing from rail 14 through switch 22 and inductor 18 will charge capacitor C2 via diodes D6 and D2 to the voltage across the V supply at rail 14. The current flowing through inductor 18 is then maintained in the same direction via diode D3.

In summary, when one of the transistors is switched

16

off, and the free wheel diode is clamping, inductive load current does not discharge the snubber capacitor in the off switch circuit because it is blocked by the isolation diode in the off circuit. If the capacitor in the off circuit remains fully charged, there can be no peak charging current in the subsequently turned on transistor of the other switch circuit because the fully charged capacitor back biases the isolation diode in the off circuit, preventing any charging current from passing from the snubber capacitor.

Looking at it differently, transistor Q2 can rapidly turn on and off, connecting and disconnecting output circuit 17 from zero volt return rail 14, and yet the voltage at the emitter 21 of transistor Q1 is unaffected and remains at zero volt potential, because of the charge on capacitor C1 and the reverse vias diode D5. Similarly, transistor Q1 can turn on and off rapidly, connecting and disconnecting the output 17 to rail 12 and yet the voltage at collector 23 of transistor Q2 will remain at the level of V supply on rail 12, because of the charge on capacitor C2 and the reverse biased isolation diode D6.

It should also be noted that one requirement of the load is that its inductive L/R time constant be large with respect to the switching times of the power device.

(Not the time the power device is switched on for, but the time of

17

the switching transition.)

Most switching systems such as D.C. motors or electronically commutated motors have long L/R time constants and therefore meet this criterion. As a result loads of this type ensure that switching systems of the type depicted in Figure 1 can control current and dissipate switching losses and yet keep current ripple in the load at a low level.

It should also be noted that when the system is first powered up, the initial charge on the snubber capacitor may be dependent on any additional circuitry that has been added on the totem pole switch circuit for purposes of control. The turn on of the first transistor will then charge or discharge the snubber capacitors to their correct potential so that operation of the circuit as discussed above will take place. The first turn on of a transistor will have current flowing from the snubber capacitors from both switch circuits into the on transistor. However, the inductor load current is effectively zero because of the long L/R time constant. This confines the absolute current in the transistors during the first transition to the capacitive currents. Some of this current is controlled by the transistor switch $dV/dt$. For some switching systems, the absence of inductive current may result in a slower turn on $dV/dt$ across the transistor which in turn will lower the potential capacitive current flowing in the transistor during the transition. Therefore if the circuit is designed to handle these capacitive currents with zero inductive load current, the use of the additional isolation diodes will protect the transistor switches from excessive capacitive current when full inductive load current is flowing through the load.

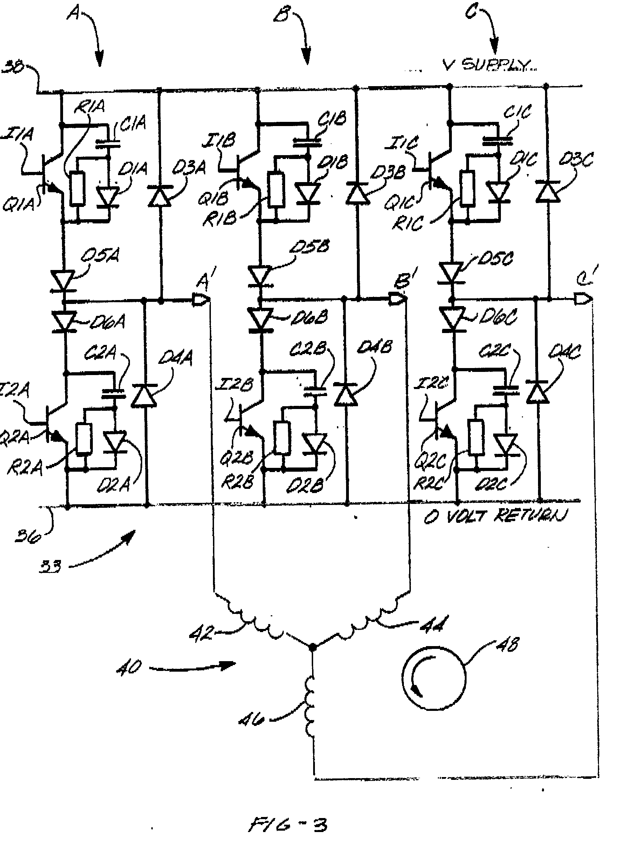

Consider now the alternative embodiment of the invention depicted in Figure 2. Figure 2 depicts a totem pole bridge 10 and an inductive load and switch circuit 20 identical to that depicted in Figure 1. However, the details of the load and related switches are exemplified by a block for simplicity.

AND gates 28 and 32 are connected, respectively, to the base electrodes of transistors Q1 and Q2. Microprocessor 26 has outputs 26a and 26b connected to inputs of, respectively, AND gate 28 and AND gate 32. Inputs of delay circuits 30 and 34 are connected to outputs respectively, 26a and 26b and have their outputs connected, respectively, to AND gates 28 and 32. As a result, a turn on pulse such as that depicted in Figure 2 at either of outputs 26a or 26b will not be effective to cause the corresponding AND gate to turn on the corresponding transistor until after a delay period determined by the corresponding delay circuits.

In operation, microprocessor 26 applies a positive pulse to output 26a, thus enabling one of the inputs to AND gate 28. Delay circuit 30 is responsive to the pulse for

19

forming a true signal at the second input to the AND gate 28, but only after a delay period. The delay period is selected so that it is sufficiently long as to enable the inductive load to fully charge the snubber capacitor in switch circuit 10b after its transistor has been switched off.

AND gate 32 and delay circuit 34 are similar to AND gate 28 and delay circuit 30 in construction and operation.

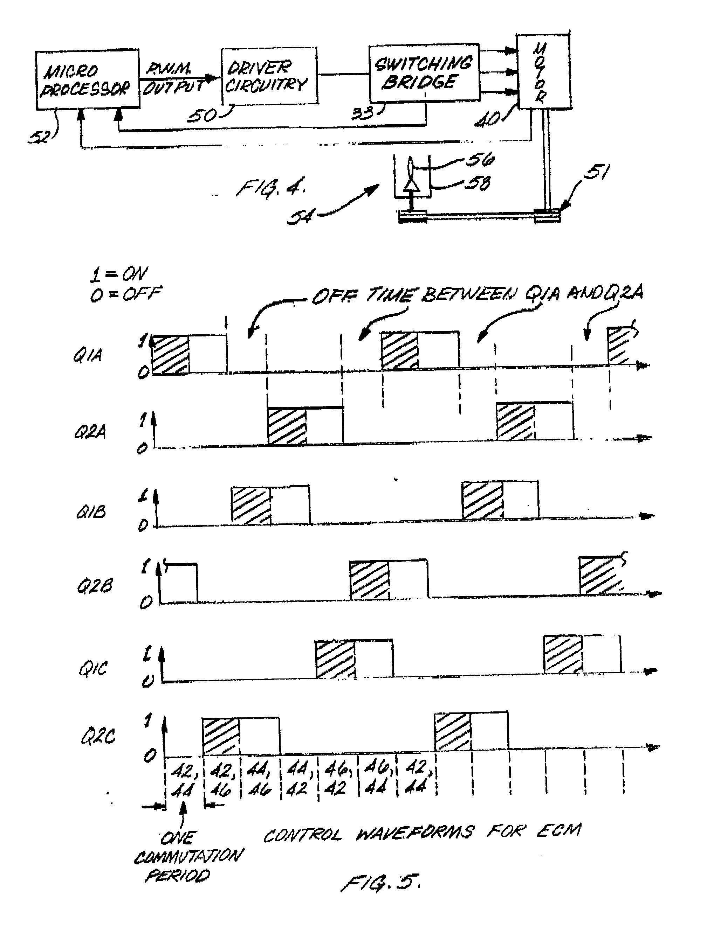

Figure 3 depicts a multiple stage totem pole snubber bridge driving a three winding three phase electronic commutated motor 40 for use in the laundry machine of Figure 4. The totem pole snubber bridge 35 of Figure 3 is similar to that depicted in Figure 1 except that there are three stages, each stage having two switch circuits connected in a serial totem pole fashion similar to that depicted for the single stage at 10 in Figure 1. Each stage has its components corresponding to those depicted in Figure 1, identified by the same symbols but with a letter added at the end to distinguish between the three stages. Thus there are three totem pole stages, identified A, B, and C with the Stage A components identified with the suffix A, the Stage B components identified with the suffix B, and the Stage C components identified with the suffix C, each stage being connected between a positive rail 38 of V supply and a negative or zero volt return rail 36 of V supply. The outputs of each of stages A, B and C are identified, respectively, by the symbols A', B' and C'.

20

The motor 40 has motor windings 42, 44 and 46 with one end of each connected together at a common point in a star arrangement with the opposite ends of windings 42, 44 and 46 connected, respectively, to outputs A', B' and C'. The windings are energized in a sequence so as to rotate a motor rotor 58.

Referring now to Figures 3 and 4, the multistage totem pole snubber bridge 33 has input circuits 11A, 12B and 11B, 12B, and 11C, 12C, connected to the base electrodes of the transistors in, respectively, totem pole stages A, B and C. These input circuits are in turn connected to the output of driver circuitry 50 which in turns receives pulse width modulated output and other control signals from a microprocessor 52. Such a microprocessor is disclosed in detail in copending patent application claiming priority from New Zealand patent application no. 207430 filed 8th march 1984 and the entire contents of that application is incorporated by reference herein.

Figure 5 depicts the control waveforms for the electronic commutated motor system which includes switching bridge 33 depicted in Figure 3. The on and off periods of each of transistors Q1A, Q2A, Q1B, Q2B, Q1C and Q2C, are depicted in a waveshape diagram where 1 depicts an on or enable condition where the transistor is in a low impedance condition, and a 0 or off condition where the transistor is in a high impedance condition.

The cross hatched part of the waveform indicates where a

0157220

21

transistor is under PWM control and can either be in a low impedance or high impedance state depending on the output of the PWM controller. The remainder of the waveform shows where the transistor is statically on or statically off.

Additionally the waveshape diagrams for each transistor are shown in relation to the waveshape diagrams of the other circuits so as to depict the sequence with which the switches are turned on and turned off. Additionally, the windings of the motor depicted in Figure 3 which are associated with the switches and therefore may be on, are indicated along the bottom of Figure 5 for reference purposes. A pair of switches are on at the same time so as to connect the end of one winding to one side of the end of another winding and to the other side of the source of supply. It should also be noted that the same two switches will only be on simultaneously for a commutation period.

Thus transistor Q1A will be on for two full commutation periods whereas transistor Q2B will be on for one commutation period during which positive current will flow from winding 42 through winding 44. Subsequently, transistor Q2B will be turned off and transistor Q2C will be turned on by the microprocessor, causing Q1A and Q2C to be the on pair positive current continues flowing through winding 42 and then through new winding 46. Transistor Q2B is turned off prior to the time that transistor Q2C is turned on and therefore decay current in motor winding 44 continues to flow through free wheel diode D3B in the same

22

stage B as transistor Q2B. However, isolation diode D5B prevents any discharge of the snubber capacitor C1B. With transistors Q1A and Q2C on, positive current then flows from winding 42 through winding 46 until transistor Q1A turns off, and transistor Q1B turns on. When transistor Q1A turns off, the decay current in winding 42 flows through free wheel diode D4A. However, isolation diode D5A prevents any discharge of snubber capacitor C2A.

Note, however that the microprocessor delays turn on of transistor Q2A one commutation P.W.M. period after the turn on of transistor Q1A. In other words the microprocessor 52 is arranged so that it does not turn on the transistor Q2A in stage A for one commutation period after the turn off of transistor Q1A. This delay period is used by the lower switching circuit of stage A and the decay current in winding 42 to fully charge snubber capacitor C1A so that when transistor Q2A in the lower switch circuit of stage A is turned on, it does not receive any charging current from snubber capacitor C1A.

As indicated above, a pulse width modulated (P.W.M.) control is used for driving the motor. Therefore the width of the current pulses provided by the switches is controlled so as to provide the requisite average driving current to start the motor, accelerate the motor, and drive the motor at full speed. Microprocessor 52 is arranged to turn on and turn off one of the two switches which are indicated in Figure 5 to be in the on condition, in order

23

to provide the pulse width modulated driving signals.  The particular switch which is pulse width modulated is indicated by shaded lines in Figure 5.

The motor is preferably a multiphase electronically commutated motor but may be a D.C. motor such as a brush type D.C. motor.

The power supply (V supply) is preferably a rectified A.C. current without any filtering.  As a result, the multiple harmonic feedback into the A.C. lines, which is attendant with filtered power supplies, is avoided.  Significantly, an embodiment of the invention using the described method avoids the need for a filtered source of power to achieve the desired motor power.

Referring back to Figure 4, as indicated above, Figure 4 is an embodiment of the invention in a laundry machine.  The rotor 48 of the motor 40 is directly connected through shafts and pulleys indicated generally at 51 to an agitator 56 in a washing machine 54.  Washing machine 54 also includes a spin tub 58.  Microprocessor  52 normally applies the control signals to the switching bridge, causing the motor 40 to reciprocally rotate the agitator 56.  Microprocessor 52 also controls the switching bridge 33 so as to drive the agitator continuously in one direction at high speed, the agitator and spin tub being linked together so that when the agitator is rotated at high speed in one direction, the spin tub is rotated along at the same speed.  Such a washing machine is disclosed in

0157220

24

U.S. Patent No. 3, 914,963 Brimer.

In summary the present invention enables RCD snubber controlled power switches connected in a totem pole output configuration to be operated within their safe operating areas by controlling the interflow of current between the power switches and their RCD snubber networks. As a result the power switches can be used to control higher currents and yet use less expensive power switches, or to operate the power switches within greater safety margins and reliability. In the embodiment of the invention involving a washing machine, the speed and direction control for the electronically commutated motor can be cyclicly reversed to give agitator forward and reverse action over something less than $2\pi$ radians of movement, and yet spin the agitator at a high enough speed to pick up and rotate the spin tub or bowl in one direction of rotation.

Also of significant importance in a laundry machine is the fact that the voltage waveform in the motor windings is maintained free from effects of the snubbers. Thus because of the low leakage from the snubber capacitors due to the isolation diodes, the snubbers stay charged even during the period when neither transistor is operative. As a result the voltage at the end of the motor windings can be measured to accurately determine when the motor rotor has stopped rotation or for other control purposes without the disruptive distortion of the voltage due to capacitive effects of the snubbers.

0157220

25

Although an exemplary embodiment of the invention has been disclosed for purposes of illustration, it will be understood that various changes, modifications and substitutions may be incorporated into such embodiment without departing from the spirit of the invention s defined by the claims appearing hereinafter.

The features disclosed in the foregoing description, in the following claims and/or in the accompanying drawings may, both separately and in any combination thereof, be material for realising the invention in diverse forms thereof.

- 26 -

The Claims Defining the Invention Are As Follows:

1. A switching bridge having at least one switching stage for rapidly coupling and uncoupling at least one inductive load across a source of power for pulsing current therethrough in either of two directions, the at least one stage comprising:

first and second switch circuits, each said switch circuit comprising, corresponding thereto,

a power switch, the power switch of each said switch circuit being coupled together to the other one in a series circuit path across said source of power, each power switch, when on, being adapted for serially coupling a different side of the source of power to an output circuit and, when off, being adapted for disabling the coupling, the load being coupled between the output circuit and the other side of the source of power from the one coupled by one of the power switches to the output circuit,

a capacitor snubber coupled across the power switch, in the corresponding switch circuit, for limiting rate of change of voltage across such power switch, in at least one direction of voltage change;

unidirectional circuit means coupled to such output circuit for directing decay current, flowing in the at least one load, in a loop back through the at least one load upon turning the power switch, corresponding to the other said switch circuit, from on to off; and

further unidirectional circuit means located in the series circuit path for inhibiting the discharge of charge previously stored in the capacitor snubber of the corresponding switch circuit until the power switch of the corresponding switch circuit is turned on, each of the further unidirectional circuit means also being adapted to be maintined in a back biased condition, due to the charge stored in the capacitor snubber, of the corresponding switch circuit, to thereby substantially isolate the corresponding switch circuit from signal changes in the other of the switch circuits.

2. The bridge of Claim 1 wherein each switch circuit is adapted to enable decay current in the load, after turn off of the corresponding power switch, to charge the capacitor snubber to a sufficiently high level so as to maintain the further unidirectional circuit means in said back biased condition.

3. The bridge of either Claims 1 and 2 wherein the snubber of each said switch circuit comprises still further unidirectional circuit means coupled in a circuit with at least one capacitor across the power switch of the corresponding switch circuit and at least one resistor connected in parallel with said still further unidirectional circuit means coupled in a circuit for providing, across such power switch, a lower impedance path to the flow of current and wherein the further unidirectional circuit means cooperates with the still further unidirectional circuit means and the at least one capacitor in the same switch circuit for providing a low impedance path, after turn off of the power switch in the corresponding switch circuit, to the decay current in the load.

4. The bridge of any one of the preceding Claims and including means for sequentially turning on and off the power switch corresponding to one switch circuit and thereafter, after a delay sufficient to permit the charge to be stored in said capacitor snubber, sequentially turning on and off the power switch corresponding to the other switch circuit.

5. The bridge of any one of the preceding Claims and including means for delaying the turn on of the power switch of any switch circuit until a predetermined time period has elapsed since the turn off of the power switch of the other switch circuit.

6. The bridge of any one of the preceding Claims and including a plurality of said stages for rapidly and sequentially pulsing the current through the windings of a multiple phase electronically commutated motor or a D.C. motor.

7. A switching bridge having at least one switch stage for rapidly coupling and uncoupling at least one inductive load across a source of power for pulsing current therethrough in either of two directions, the at least one stage comprising:

    first and second switch circuits, each said switch circuit comprising, corresponding thereto,

a power switch, the power switch of each said switch circuit being coupled together to the other one in a series circuit path, across said source of power each power switch, when on, being adapted for serially coupling a different side of the source of power to an output circuit and, when off, being adapted for disabling the coupling, the load being coupled between the output circuit and the other side of the source of power from the one coupled to the output circuit;

a capacitor snubber coupled across the power switch, in the corresponding switch circuit, for limiting rate of change of voltage across such power switch, in at least one direction of voltage change;

unidirectional circuit means coupled to such output circuit for directing decay current, flowing in the at least one load, in a loop back through the at least one load upon turning the power switch, corresponding to the other said switch circuit, from on to off; and

further unidirectional circuit means located in the series circuit path, the interrelationship between said switch circuit and said at least one load being such that the discharge of charge stored in the capacitor snubber of either switch circuit is inhibited by the further unidirectional circuit means of such switch circuit, until the power switch of such switch circuit is on.

8. An electronically commutated motor drive, comprising a

5

0157220

multiple phase motor having a plurality of windings connected in star fashion, a plurality of stages of switching bridges for rapidly and sequentially coupling the motor winding across a source of power for pulsing current therethrough in either of two directions to drive the motor, each said stage comprising:

first and second switch circuits, each said switch circuit comprising, corresponding thereto,

a power switch, the power switch of each said switch circuit being coupled together to the other one in a series circuit path across said soruce of power, each power switch, when on, being adapted for serially coupling a different side of the source of power through an output circuit and, when off, being adapted for disabling the coupling, the free end of a different one of the windings being coupled to the output circuit of each switch circuit, the power switches of one of the first and one of the second switch circuits of different stages being on simultaneously to couple the winding across the source of power,

a capacitor snubber coupled across the power switch, in the corresponding switch circuit, for limiting rate of change of voltage across such power switch, in at least one direction of voltage change,

unidirectional circuit means coupled to such output circuit for directing decay current, flowing in the at least one load, in a loop back through the at least one load upon turning the power switch, corresponding to the other said switch circuit in the same stage, from on to off, and

further unidirectional circuit means located in the series circuit path for inhibiting the discharge of charge previously stored in the capacitor snubber of the corresponding switch circuit until the power switch of the corresponding switch circuit is turned on, each of the further unidirectional circuit means also being adapted to be maintained in a back biased condition, due to the charge stored in the capacitor snubber, of the corresponding switch circuit, to thereby substantially isolate the corresponding switch circuit from signal changes in the other of the switch circuits in the same stage.

9. A laundry machine for driving an agitator reciprocally in either of two directions of rotation and for spinning the agitator and a spin tub at high speed in at least one direction comprising an electronically commutated multiphase motor having multiple windings connected in a star fashion and a rotor, driven by the windings, directly coupled for so driving the agitator, and, if required the spin tub, a plurality of stages of switching bridges for rapidly and sequentially coupling the motor winding across a source of power for pulsing current therethrough in either of two directions to drive the motor, each said stage comprising:

first and second switch circuits, each said switch circuit comprising, corresponding thereto,

a power switch, the power switch of each said switch circuit being coupled together to the other one in a series circuit path, each power switch, when on, being adapted for serially coupling a different side of the source of power through an output circuit and, when off, being adapted for disabling the coupling, the free end of a different one of the windings being coupled to the output circuit of each switch circuit, the power switches of one of the first and one of the second switch circuits of different stages being on simultaneously to couple the windings across the source of power,

a capacitor snubber coupled across the power switch, in the corresponding switch circuit, for limiting rate of change of voltage across such power switch, in at least one direction of voltage change,

unidirectional circuit means coupled to such output circuit for directing decay current, flowing in the at least one load, in a loop back through the at least one load upon turning the power switch, corresponding to the other said switch circuit in the same stage, from on to off, and

further directional circuit means located in the series circuit path for inhibiting the discharge of charge previously stored in the capacitor snubber of the corresponding switch circuit until the power switch of the corresponding switch circuit is turned on, each of the further unidirectional circuit means also being adapted to be maintained in a back biased condition, due to the charge stored in the capacitor snubber, of the corresponding switch circuit, to thereby substantially isolate the corresponding switch circuit from signal changes in the other of the switch circuits in the same stage.

10. A laundry machine according to Claim 9 and including a microprocessor for enabling the power switches to be turned on in a sequence of pairs of power switches, each power switch of each pair being from a first switch circuit of one stage and the other power switch of each pair being from the second switch circuit of another stage.

11. The bridge and Claim 10 or Claim 11 wherein each switch circuit is adapted to enable decay current in one of the windings, after turn off of the corresponding power switch, to charge the capacitor snubber to a sufficiently high level so as to maintain the further unidirectional circuit means in said back biased condition.

12. The bridge of either of any one of Claims 9 to 11 wherein the snubber of each said switch circuit comprises still further unidirectional circuit means coupled in a circuit with at least one capacitor across the power switch of the corresponding switch circuit and at least one resistor connected in parallel with said still further unidirectional circuit means for providing, across such power switch, a lower impedance path to the flow of current and wherein the further unidirectional circuit means cooperates with the still further unidirectional circuit means and the at least one capacitor in the same switch circuit for providing a low impedance path, after turn off of the power switch in the corresponding switch circuit, to the decay current in one of the windings.

13. The bridge of any one of Claims 9 to 12 comprising means for sequentially turning on and off the power switch corresponding to one switch circuit and thereafter, after a delay sufficient to permit the charge to be stored in said capacitor snubber, sequentially turning on and off the power switch corresponding to the other switch circuit.

14. The ridge of Claim 12 or Claim 14 includings means for delaying the turn on of the power switch of any switch circuit until a predetermined time period has elapsed since the turn off of the power switch of the other switch circuit.

15. A method of supplying electrical power to an inductive load using resistor-capacitor-diode snubber networks (RCD snubbers) in conjunction with switching bridge circuitry in which a pair of power switching devices actuated by driving circuitry and logic are connected in totem pole output stage configuration, said method comprising the steps of driving a first said switching device to turn on to supply power to said inductive load so tht energy is stored therein and work done thereby while keeping the other switching device in the turned off state, driving said first switching device to turn off after its snubber capacitance has been discharged to a desired level,
permitting energy stored in the inductive load to charge
the capacitance of the RCD snubber controlling said first
switching device to a desired potential before driving a
second said second switching device to turn on to supply
power again to said inductive load so that energy is stored
therein and work done thereby, driving said second
switching device to turn off after its snubber capacitance
has been discharged to a desired level, permitting energy
stored in the inductive load to charge the capacitance of
the RCD snubber controlling said second switching device to
a desired potential before again, driving said first
switching device to turn on, substantially preventing
energy from the RCD snubber controlling a selected
switching device from passing through the other of said
switching devices during the above steps, and repeating
said sequence of steps as desired.

16. The method of Claim 15 comprising the steps of
connecting diodes between the switching devices and the
output rail of the totem pole output stages.

17. A method of operating a total pole output stage using a
first and a second resistor-capacitor-diode snubber network
(RCD snubber) controlled power switching device, said
method comprising the steps of controlling the interchange
of voltages between said switching devices so that voltages
appearing in one said RCD snubber controlled power
switching devices do not appear in the other said RCD snubber controlled power switching devices.

18. The method of Claim 17 comprising the steps of permitting only unidirectional current flow between said switching devices and the output rail of the circuit.

19. The method of Claim 17 or Claim 18 comprising the steps of having both said switching devices turned off as a transition switching stage between turning one switching device off and the other switching device on for a time sufficient to allow energy supplied from energy stored in the inductive load to charge one or the other capacitor in the RCD snubber circuits to a desired potential level.

20. An electronic power control circuit for supplying an inductive load, said circuit including a first switching device and a second switching device connected in totem pole output stage configuration, each said switching device having connected in parallel with it a resistor-capacitor-diode snubber network, and each said switching device being connected to said load and to driving circuitry and logic including means to drive said first switching device to turn on to supply power to said inductive load so that energy is stored therein and work done thereby while keeping the said second switching device in the turned off state, means to drive said first switching device to turn off, means to permit energy stored in the inductive load to charge the capacitance of the RCD snubber controlling said first switching device to a desired potential, means to delay driving of said second switching device to turn on until said desired potential has been reached, means to drive said second switching device to turn on power again to said inductive load so that energy is stored therein and work done thereby, means to drive said second switching device to turn off, means to permit energy stored in the inductive load to charge the means capacitance of the RCD snubber controlling said second switching device to a desired potential, means to delay turning on of said first switching device before again driving said first switching device to turn on, and means to substantially prevent energy from the RCD snubber controlling a selected switching device from passing through the other of said switching devices.

21. Apparatus for supplying electric power to an inductive load, said apparatus comprising a pair of power switching devices connected with output stages in totem pole configuration between a voltge rail, a load rail and a zero rail, the switching devices being connected to the load rail through unilateral conductivity devices of the same polarity and each switching device having in parallel therewith a resistance-capacitance-diode snubber circuit and a free wheeling diode and each switching device being driven by driving circuitry and logic so that on a first one of said switching devices being turned on, energy is supplied to said inductive load and on said driving circuitry turning off, that switching device energy from the inductive load charges the capacitance of the RCD snubber in parallel with that device to a desired potential and said driving circuitry and logic then drives the second switching device to turn on to supply further energy to said inductive load and on said driving circuitry and logic turning off said second switching device

the capacitance of the RCD snubber in parallel therewith is charged by energy from said inductive load to a desired potential before said first switching device is turned on, said unilateral conductivity devices substantially preventing energy from the RCD snubber controlling one switching device from passing through the other switching device.

22. An electronic power circuit for supplying power to an inductive load comprising at least one bridge circuit having a first and a second power switching device connected in totem pole configuration, each switching device having a driving circuitry and logic and each having connected in parallel therewith a resistor-capacitor-diode snubber network, a first and a second series diode connected between said switching devices, the polarity of said series diode connection being the same as the polarity of the switching device connection with an output rail being connected between said first and second series diodes, a first free wheeling diode connected in opposite polarity to that of said first switching device between said output rail and a voltage rail and a second free wheeling diode connected in opposite polarity to that of

0157220

14

said second switching device connected between a zero voltage rail and said output rail, said first switching device and said first series diode being connected between said voltage rail and said output rail and said second switching devices and said second series diode being connected between said output rail and said zero voltage rail, said driving circuitry and logic being constructed and arranged to drive said switching devices in a manner such that in transient stages after a switching device has been on and is then turned off, turn on of the other switching device is delayed until the capacitance of the RCD snubber of the first switching device has been charged to a desired potential by energy from the inductive load.

23. Apparatus for supplying electric power to an inductive load when constructed arranged and operable substantially as herein described with reference to and as illustrated by the accompanying drawings.

24. A method of supplying electric power to an inductive load when effected substantially as herein described with reference to and as illustrated by the accompanying drawings.

25. A switching circuit for switching one end of an inductive load to either of two sides of a source of power comprising first and second power switches coupled in series with each other and adapted for coupling across the source of power; first and second resistor, capacitor and diode snubber circuits coupled in parallel with,

15

respectively, the first and second power switches; first and second diodes, individually controllable to a back biased condition by the capacitors of, respectively, said first and second snubbers, and coupled in series with, respectively, the first and second power switches and to an output circuit which output circuit is for coupling to such load; a third diode coupled in parallel with the first power switch and the first diode and to such output circuit for receiving decay current from the load; and a fourth diode coupled in parallel with the second power switch and the second diode and to such output circuit for receiving decay current from the load.

26. An electronic power control circuit as claimed in any one of Claims 20 to 23 in combination with and driven by a pulse width modulated current controller as claimed in any one of Claims 21 to 40 or 45 and 46 of copending patent application no.          claiming priority from New Zealand Patent Application No. 207430 filed 8 March 1984 the entire contents of which are incorporated by reference herein.

FIG-1

113    0157220

213    0157220

FIG-3

3/3

0157220

FIG. 4.

1 = ON
0 = OFF

OFF TIME BETWEEN Q1A AND Q2A

QIA

Q2A

QIB

Q2B

QIC

Q2C

| 42, 44 | 42, 46 | 44, 46 | 44, 42 | 46, 42 | 46, 44 | 42, 44 |

ONE COMMUTATION PERIOD

CONTROL WAVEFORMS FOR ECM

FIG. 5.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | CH-A- 403 924 (WESTINGHOUSE ELECTRIC CORP.) * Figure 5, elements 51,521,524,561,564,551,554,571,574; page 3, line 115 - page 4, line 33; figure 6 * | 1-3,7 | H 03 K 17/08 H 02 H 7/122 H 02 M 7/538 |
| A |  | 20-22, 25 |  |
| A | US-A-4 167 776 (N.H. NYGAARD) * Figure 2; column 1, lines 41-60; column 2, line 33 - column 4, line 8 * | 1-3,6-8 |  |
| A | * Column 1, lines 41-46 * | 5 | TECHNICAL FIELDS SEARCHED (Int. Cl.4) |
| A | GB-A-2 060 299 (BORG-WARNER CORP.) * Figure 1; page 2, line 80 - page 3, line 6 * | 1-3,6-8,20-22,25 | H 02 H 7/122 H 02 M 7/537 H 02 M 7/538 H 02 P 7/00 H 03 K 17/08 H 03 K 17/66 |
| D,A | US-A-3 914 963 (C.M. BRIMER) |  |  |

The present search report has been drawn up for all claims

| Place of search | Date of completion of the search | Examiner |
|---|---|---|
| BERLIN | 23-05-1985 | ARENDT M |